Europäisches Patentamt

European Patent Office

Office européen des brevets

(11) Veröffentlichungsnummer: **0 235 731**
**A1**

## EUROPÄISCHE PATENTANMELDUNG

(21) Anmeldenummer: 87102628.2

(22) Anmeldetag: 24.02.87

(51) Int. Cl.4: **C23C 14/50** , **H01J 37/20**

(30) Priorität: 26.02.86 DE 3606152

(43) Veröffentlichungstag der Anmeldung:
**09.09.87 Patentblatt 87/37**

(84) Benannte Vertragsstaaten:
**CH DE FR GB IT LI**

(71) Anmelder: **BASF Aktiengesellschaft**
**Carl-Bosch-Strasse 38**
**D-6700 Ludwigshafen(DE)**

(72) Erfinder: **Scheffel, Dieter**
**Keplerweg 12**
**D-6708 Neuhofen(DE)**
Erfinder: **Maurer, Gerd, Dr.**
**Am Muehlpfad 10**
**D-6750 Kaiserslautern 31(DE)**
Erfinder: **Bender, Rainer, Dr.**
**Reinhold-Schneider-Weg**
**D-7602 Oberkirch(DE)**

(54) **Halterung für Substratplatten auf Trägerplatten.**

(57) Eine Trägerplatte (1) ist mit Öffnungen (2) zur Aufnahme der Substratplatten versehen. Am Rande der unteren Hälfte (3) der Öffnungen sind mindestens zwei Stützelemente (4) zur Halterung der Substratplatten angeordnet, wobei die Stützelemente jeweils eine Vertiefung (8) zur sicheren Auflage der Substratplatten aufweisen.

FIG.1A

FIG.1

EP 0 235 731 A1

## Halterung für Substratplatten auf Trägerplatten

Die Erfindung betrifft eine Halterung für Substratplatten auf Trägerplatten zur beidseitigen Oberflächenbearbeitung der Substratplatten in Bearbeitungsanlagen, mit mindestens einer Öffnung in der Trägerplatte zur Aufnahme der Substratplatte.

Eine vollflächige Bearbeitung von Substratplatten, wie Reinigen oder Glätten bzw. Aufrauhen oder Beschichten, wird wegen der Halterung bzw. Auflage der Platten in der Bearbeitungsanlage für beide Plattenseiten gewöhnlich nacheinander durchgeführt. Ein Beispiel ist die Herstellung von Metalldünnfilmplatten, bei der nach einem Ätzen der Oberflächen mittels Kathodenzerstäubung ein Metalldünnfilm auf den Plattenoberflächen erzeugt wird.

Eine beidseitige Bearbeitung gleichzeitig wäre im Hinblick auf eine höhere Bearbeitungsgeschwindigkeit von großem Vorteil. Geeignete Trägerplatten für die Substratplatten stehen, wie eingangs geschildert, in der Fachindustrie zur Verfügung (Firmenprospekt Fa. Leybold-Heraeus GmbH, Hanau).

Ein Problem ist jedoch dabei, daß beim Halten der Platten Flächenteile, gewöhnlich der Plattenrand, abgedeckt werden, die der Bearbeitung dadurch nicht zugänglich sind.

Demgemäß bestand die Aufgabe, eine Halterung zu entwickeln, mittels derer Substratplatten auf einer Trägerplatte der eingangs geschilderten Art zur Beschickung einer Bearbeitungsanlage einfach, schnell und sicher aufgenommen und gehalten werden können.

Die Lösung der Aufgabe besteht erfindungsgemäß darin, daß die Halterung aus mindestens zwei Stützelementen besteht, die am Rande der unteren Hälfte der Öffnung beidseitig deren vertikalen Mittellinie befestigt sind und jeweils eine Vertiefung zur Auflage der Substratplatte aufweisen.

Für eine sichere und spannungsfreie Auflage der Substratplatte ist es vorteilhaft, nahe einem der Stützelemente ein weiteres Stützelement anzuordnen.

Weitere Einzelheiten und Vorteile der Halterung nach der Erfindung sind in der nachfolgenden Beschreibung und Zeichnung eines Ausführungsbeispiels enthalten.

Es zeigen

Figur 1 eine Trägerplatte mit in Matrixform angeordneten Öffnungen, von denen eine in Figur 1A vergrößert dargestellt ist.

Figur 2 und 3 ein in die Trägerplatte einsetzbares Stützelement als Halterung für eine Substratplatte in einer Front-und Seitenansicht.

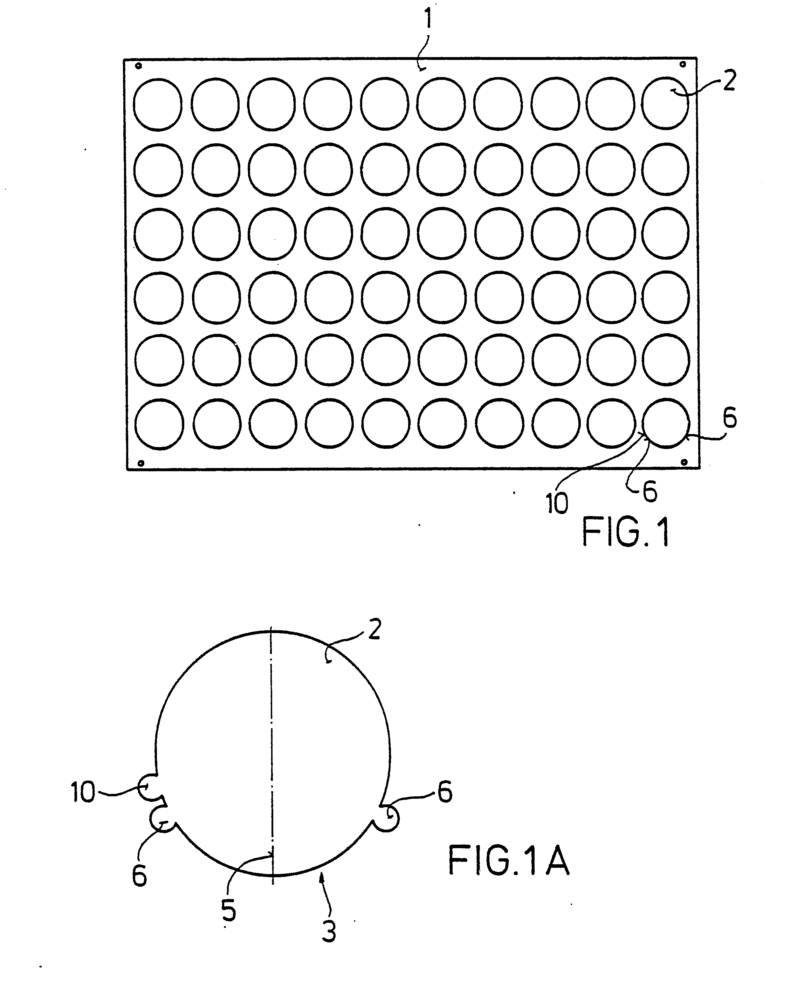

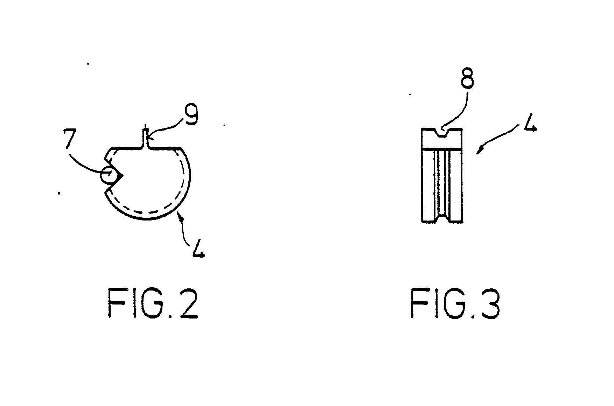

Eine -wie bereits vorstehend erwähnt -für den Einsatz zur Verfügung stehende Trägerplatte 1 (Figur 1) weist mehrere, in Matrixform angeordnete Öffnungen 2 auf, die in Form eines Langloches vom runden Ausschnitt etwas abweichen, so daß die Substratplatten sicher darin aufgenommen werden können. Zur Halterung der Substratplatten in den Öffnungen sind an deren unteren Randhälfte 3 (Figur 1A) jeweils wenigstens zwei Stützelemente vorgesehen, die in einer vorteilhaften Ausgestaltung aus Scheiben 4 (Figur 2 und 3) bestehen, welche vorzugsweise symmetrisch zur vertikalen Öffnungsmittellinie 5 in Aussparungen 6 der Trägerplatte eingelassen und darin mittels eines Spannstiftes 7 arretiert sind.

Zur sicheren Auflage der Substratplatten auf den Scheiben 4, die zweckmäßigerweise die gleiche Materialstärke wie die Trägerplatte aufweisen, sind diese mit einer am Umfang umlaufenden, keilförmigen Vertiefung 8 versehen. Ferner sind die Scheiben in der Weise abgeflacht, daß sie mit dem Rand der Öffnungen 2 abschließen und an dieser Stelle einen mit der Vertiefung 8 versehenen Steg 9 für die Auflage der Substratplatte aufweisen. Damit ist erreicht, daß eine Abschattung ausschließlich im Bereich der Außenfase auftreten kann.

Die erfindungsgemäße Halterung für die Substratplatten ist nicht auf die vorstehend beschriebene Ausführungsform der Stützelemente beschränkt, sondern schließt auch andere, die bestimmungsgemäße Funktion erfüllende Ausführungen ein.

Hinsichtlich einer sicheren und insbesondere spannungsfreien Auflage der Substratplatten hat es sich als vorteilhaft erwiesen, nahe einem der Stüzelemente -etwa zwischen 15 und 20 Winkelgraden -ein weiteres Stützelement 10 vorzusehen.

Durch die erfindungsgemäße Halterung für die Substratplatten ist erreicht, daß diese im wesentlichen an ihrer Außenfase aufliegen und dadurch sowohl Beschädigungen als auch ein Abdecken des äußeren Plattenflächenbereiches gegen die Oberflächenbearbeitung vermieden werden.

**Ansprüche**

1. Halterung für Substratplatten auf Trägerplatten zur beidseitigen Oberflächenbearbeitung der Substratplatten in Bearbeitungsanlagen, mit mindestens einer Öffnung (2) in der Trägerplatte (1) zur Aufnahme der Substratplatte, dadurch gekennzeichnet, daß die Halterung aus mindestens zwei Stützelementen (4) besteht, die am Rande der unteren Hälfte (3) der Öffnung (2) beidseitig deren vertikalen Mittellinie (5) befestigt sind und jeweils eine Vertiefung (8) zur Auflage der Substratplatte aufweisen.

2. Halterung nach Anspruch 1, dadurch gekennzeichnet, daß nahe einem der Stützelemente (4) ein weiteres Stützelement (10) angeordnet ist.

3. Halterung nach Anspruch 1 und 2, dadurch gekennzeichnet, daß die Stützelemente (4) als Scheiben mit am Umfang umlaufender Vertiefung (8) ausgebildet sind und am Rande der unteren Hälfte (3) der Öffnung (2) beidseitig deren vertikalen Mittellinie (5) in Aussparungen (6) eingelassen und darin mittels eines Spannstiftes (7) arretiert sind.

4. Halterung nach Anspruch 1 bis 3, dadurch gekennzeichnet, daß die als Stützelemente (4) dienenden und in eine Aussparung (6) der Trägerplatte (1) eingelassenen Scheiben durch eine Abflachung mit dem Rand der Öffnung (2) abschließen und einen mit einer Vertiefung (8) versehenen Steg (9) für die Auflage der Substratplatte aufweisen.

FIG. 1

FIG.1A

FIG.2

FIG.3

**Europäisches Patentamt**

# EUROPÄISCHER RECHERCHENBERICHT

Nummer der Anmeldung

EP 87 10 2628

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 558 388 (W.E. GRAVES)<br>* Ansprüche 1-6; Seite 2, Zeilen 16-20; Figuren 1-10 * | 1-4 | C 23 C 14/50<br>H 01 J 37/20 |
| | --- | | |
| A | DE-A-3 411 208<br>(LEYBOLD-HERAEUS) | | |
| | --- | | |
| A | US-A-3 436 255 (D.M. HARRIS) | | |
| | --- | | |
| A | US-A-4 473 455 (R.E. DEAN) | | |
| | --- | | |
| A | PATENT ABSTRACTS OF JAPAN, Band 8, Nr. 209 (E-268)[1646], 22. September 1984; & JP-A-59 94 353 (TOSHIBA K.K.) 31-05-1984 | | **RECHERCHIERTE SACHGEBIETE (Int. Cl.4)**<br><br>C 23 C<br>H 01 J |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 18-06-1987 | ELSEN D.B.A. |